(19) Europäisches Patentamt

European Patent Office

Office européen des brevets

(11) Veröffentlichungsnummer: **0 313 741 B1**

## (12) EUROPÄISCHE PATENTSCHRIFT

(45) Veröffentlichungstag der Patentschrift: **09.12.92**

(21) Anmeldenummer: **88112755.9**

(22) Anmeldetag: **05.08.88**

(51) Int. Cl.⁵: **G11B 7/095**, H03F 1/30

(54) **Gerät zur Wiedergabe von Daten.**

(30) Priorität: 30.09.87 DE 3732941

(43) Veröffentlichungstag der Anmeldung:
**03.05.89 Patentblatt 89/18**

(45) Bekanntmachung des Hinweises auf die
Patenterteilung:
**09.12.92 Patentblatt 92/50**

(84) Benannte Vertragsstaaten:
**AT BE CH DE ES FR GB GR IT LI LU NL SE**

(56) Entgegenhaltungen:
EP-A- 0 118 178
WO-A-86/04178
WO-A-87/05171
FR-A- 2 517 154
JP-A-62 141 644

ELECTRONIC COMPONENTS AND APPLICA-
TIONS, Band 6, Nr. 4, 1984, Seiten 209,215,
Eindhoven, NL; J. NIJHOF: "An integrated
approach to CD players. Part 1: The optical
pick-up"

PATENT ABSTRACTS OF JAPAN, Band 11,
Nr. 299 (P-621)[2746], 29. September 1987,
Seite 120; & JP-A-62 92 244

PATENT ABSTRACTS OF JAPAN, Band 11,
Nr. 68 (P-553)[2515], 28. Februar 1987, Seite
37; & JP-A-61 230 631

PATENT ABSTRACTS OF JAPAN, Band 10,
Nr. 241 (P-488)[2297], 20. August 1986, Seite
81; & JP-A-61 71 423

(73) Patentinhaber: **Deutsche Thomson-Brandt
GmbH
Hermann-Schwer-Strasse 3 Postfach 1307
W-7730 Villingen-Schwenningen(DE)**

(72) Erfinder: **Kurz, Arthur
Ludwigsburgerstrasse 26
W-7500 Karlsruhe 41(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die vorliegende Erfindung betrifft ein Verfahren zur Kompensation des Offsets in einem Gerät zur Wiedergabe von Daten, die mittels einer optischen Abtastvorrichtung aus den Datenspuren eines Aufzeichnungsträgers lesbar sind, indem mindestens ein Lichtstrahl auf den Aufzeichnungsträger mittels eines Fokusregelkreises fokussierbar und mittels eines Spurregelkreises auf den Datenspuren führbar ist, indem der Lichtstrahl vom Aufzeichnungsträger auf einen Photodetektor, der aus mehreren Photodioden aufgebaut ist, reflektiert wird, mittels dem ein elektrisches Datensignal, ein Fokusfehlersignal als Regelsignal für den Fokusregelkreis und ein Spurfehlersignal als Regelsignal für den Spurregelkreis erzeugt werden, indem die Differenz der Ausgangssignale einer ersten und einer zweiten Photodiode in einem Regelverstärker gebildet wird.

Derartige Geräte, z.B. CD-Spieler, magneto-optische Geräte zur Wiedergabe und Aufzichnung, Aufzeichnungs- und Wiedergabegeräte für DRAW-Discs oder Videoplattenspieler, sind mit einer optischen Abtastvorrichtung, bestehend aus einer Laserdiode, mehreren Linsen, einem Prismenstrahlteiler und einem Photodetektor ausgestattet. Aufbau und Funktion einer optischen Abtastvorrichtung, eines sogenannten optical pick-ups, sind in electronic components & applications, Vol. 6, No. 4, 1984 auf Seite 209 - 215 beschrieben.

Der von der Laserdiode ausgesendete Lichtstrahl wird mittels Linsen auf die CD-Platte fokussiert und von dort auf einen Photodetektor reflektiert. Aus dem Ausgangssignal des Photodetektors werden die auf der CD-Platte gespeicherten Daten und der Ist-Wert für den Fokus- und für den Spurregelkreis gewonnen. In der genannten Literaturstelle wird der Ist-Wert für den Fokusregelkreis als focusing error bezeichnet, während für den Ist-Wert des Spurregelkreises der Ausdruck radial tracking error gewählt ist.

Als Stellglied für den Fokusregelkreis dient eine Spule, über deren Magnetfeld eine Objektivlinse entlang der optischen Achse bewegbar ist. Der Fokusregelkreis bewirkt nun durch Verschieben der Objektivlinse, daß der von der Laserdiode ausgesendete Lichtstrahl stets auf die CD-Platte fokussiert wird. Mittels des Spurregelkreises, der oft auch als Radialantrieb bezeichnet wird, ist die optische Abtastvorrichtung bezüglich der CD-Platte in radialer Richtung verschiebbar. Dadurch kann der Lichtstrahl auf den spiralförmigen Datenspuren der CD-Platte geführt werden.

Bei einigen Geräten ist der Radialantrieb aus einem sogenannten Grob- und einem sogenannten Feinantrieb aufgebaut. Der Grobantrieb ist beispielsweise als Spindel ausgeführt, mittels der die gesamte optische Abtastvorrichtung aus der Laserdiode, den Linsen, dem Prismenstrahltei- ler und dem Photodetektor radial verschiebbar ist. Mit dem Feinantrieb ist der Lichtstrahl in radialer Richtung z.B. um einen vorgebbaren kleinen Winkel kippbar, so daß der Lichtstrahl allein durch diese Kippbewegung ein kleines Stück entlang eines Radius der CD-Platte fahren kann.

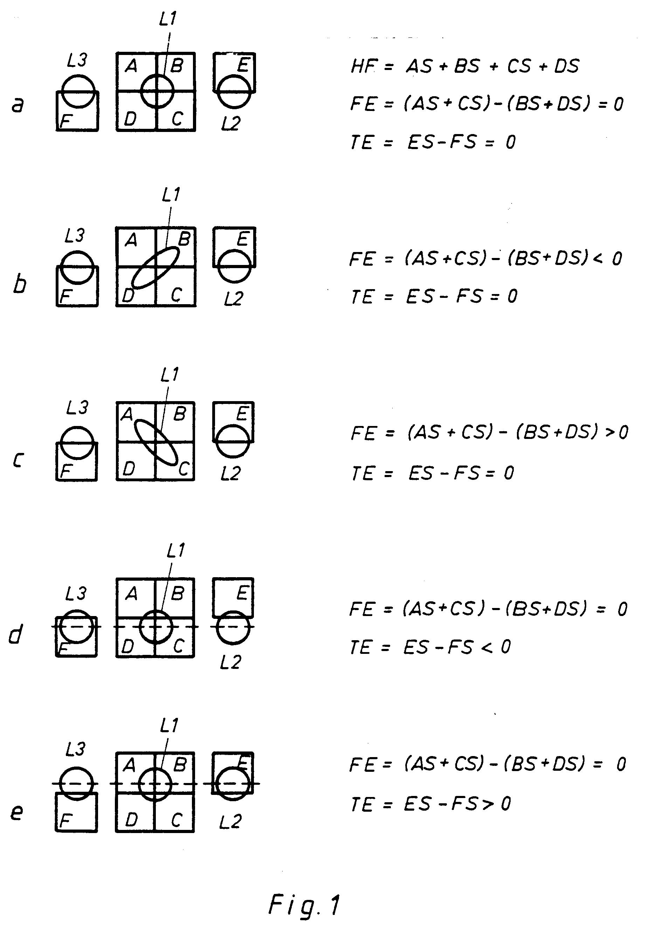

In der Figur 1 ist der Photodetektor PD der optischen Abtastvorrichtung eines CD-Spielers gezeigt, bei der drei Laserstrahlen L1, L2 und L3 auf die CD-Platte fokussiert werden. Eine derartige Abtastvorrichtung wird in der eingangs genannten Literaturstelle three-beam pick-up genannt.

Beim Photodetektor sind vier quadratförmige Photodioden A, B, C und D so zusammengefügt, daß sie wiederum ein Quadrat bilden. Bezüglich dieses aus den vier Photodioden A, B, C und D gebildeten Quadrates liegen sich zwei weitere ebenfalls quadratförmige Photodioden E und F diagonal gegenüber.

Der mittlere Laserstrahl L1, der auf die vier Photodioden A, B, C und D fokussiert wird, erzeugt das Datensignal $HF = AS + BS + CS + DS$ und das Fokusfehlersignal $FE = (AS + CS) - (BS + DS)$. Die beiden äußeren Lichtstrahlen L2 und L3, von denen der vordere L2 auf die Photodiode E, der hintere L3 auf die Photodiode F fällt, erzeugen das Spurfehlersignal $TE = ES - FS$. Mit AS, BS, CS, DS, ES und FS sind jeweils die Photospannungen der Photodioden A, B, C, D, E und F bezeichnet. Weil in der optischen Abtastvorrichtung im Strahlengang des mittleren Laserstrahls L1 eine astigmatisch wirkende Kollimatorlinse vorgesehen ist, ist der mittlere Laserstrahl L1 bei genauer Fokussierung auf dem großen Quadrat, das aus den vier Photodioden A, B, C und D gebildet wird, kreisförmig, während er bei Defokussierung Ellipsenform annimmt.

Figur 1a zeigt den Fall der Fokussierung und der genauen Spurführung, auf die später noch eingegangen wird. Weil der vom Laserstrahl L1 auf dem großen Quadrat gebildete Lichtfleck Kreisform hat, ergibt sich das Fokusfehlersignal zu $FE = (AS + CS) - (BS + DS) = 0$. Am Wert null des Fokusfehlersignals FE erkennt der Fokusregelkreis, daß genau fokussiert ist.

In der Figur 1b ist nun der eine Fall der Defokussierung, daß die CD-Platte zu weit von der Objektivlinse entfernt ist, dargestellt. Das Fokusfehlersignal FE ist negativ : $FE = (AS + CS) - (BS + DS) < 0$. Am negativen Wert des Fokusfehlersignals FE erkennt der Fokusregelkreis, daß der Abstand zwischen der CD-Platte und der Objektivlinse zu groß ist. Deshalb wird die Objektivlinse vom Stellglied des Fokusregelkreises so weit auf die CDPlatte zubewegt, bis das Fokusfehlersignal FE null wird.

Den anderen Fall der Defokussierung, daß die Objektivlinse zu nahe an der CD-Platte liegt, ist in Figur 1c gezeigt. Das Fokusfehlersignal FE hat einen positiven Wert: FE = (AS + CS) - (BS + DS) > 0. Am positiven Wert des Fokusfehlersignals FE erkennt der Fokusregelkreis, daß die Objektivlinse zu nahe an der CD-Platte liegt. Die Objektivlinse wird daher vom Stellglied so weit von der CD-Platte wegbewegt, bis das Fokusfehlersignal FE zu null wird.

Es wird nun erläutert, wie die Spurführung mittels des Spurregelkreises erfolgt.

In den Figuren 1a, 1b und 1c folgen die Laserstrahlen L1, L2 und L3 genau der Spur. Das Spurfehlersignal TE hat den Wert null. TE = ES - FS = 0.

In der Figur 1d ist der Fall dargestellt, daß die Laserstrahlen L1, L2 und L3 nach rechts von der Spur verschoben sind. Das Spurfehlersignal nimmt einen negativen Wert an: TE = ES - FS - 0. Das Stellglied des Spurregelkreises bewegt die optische Abtastvorrichtung nun so weit nach links, bis das Spurfehlersignal TE null wird.

Im entgegengesetzten Fall, wenn die Laserstrahlen nach links von der Spur verschoben sind, ist das Spurfehlersignal positiv: TE = ES - FS - 0. Nun bewegt das Stellglied des Spurregelkreises die optische Abtastvorrichtung so weit nach rechts, bis das Spurfehlersignal TE null wird.

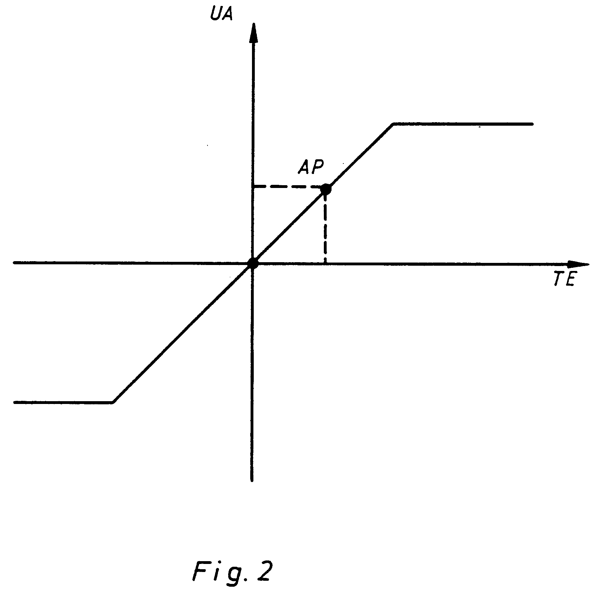

Aus der in Figur 2 dargestellten Kennlinie des Regelverstärkers für den Spurregelkreis ist der Zusammenhang zwischen der Eingangsgröße, dem Ist-Wert TE, und der Ausgangsspannung UA des Regelverstärkers erkennbar. Der ideale Arbeitspunkt des Regelverstärkers liegt im Nullpunkt des Koordinatenkreuzes, denn bei dieser Lage des Arbeitspunktes arbeitet der Regelverstärker symmetrisch. Sein Regelhub ist nach beiden Seiten gleich groß.

Aus der EP-A 0118 178 sind ein Verfahren und eine Schaltungsanordnung zur Kompensation des Offsets eines Gleichstromverstärkers bekannt.

Der Ausgang des Gleichstromverstärkers ist mit dem Eingang eines Analog-Digital-Wandlers verbunden, dessen Ausgang mit dem Eingang einer Kontrolleinheit verbunden ist. Der Ausgang der Kontrolleinheit ist mit dem Eingang eines Digital-Analog-Wandlers verbunden, dessen Ausgang mit dem ersten Eingang des Gleichstromverstärkers verbunden ist.

Mittels eines Umschalters kann an den zweiten Eingang des Gleichstromverstärkers entweder das zu verstärkende Signal oder Massepotential geschaltet werden. Die Kontrolleinheit ist über Steuerleitungen mit dem Gleichstromverstärker verbunden, um die Verstärkung und die Polarität des Gleichstronverstärkers einstellen zu können.

Zur Offsetkompensation wird der zweite Eingang des Gleichstromverstärkers auf Masse gelegt.

Der Pegel am Ausgang des Gleichstromverstärkers wird bei normaler und invertierter Polarität festgestellt. Aus der Differenz dieser beiden Pegel am Ausgang des Gleichstromverstärkers wird ein Offsetkompensationssignal erzeugt und dem ersten Eingang des Gleichstromverstärkers zugeführt.

Aufgabe der Erfindung ist es nun, ein Verfahren gemäß Oberbegriff des Anspruchs 1 so zu gestalten, daß der Regelverstärker des Spurregelkreises möglichst symmetrisch arbeitet.

Eine erste Lösung dieser Aufgabe ist durch folgende Verfahrensschritte gekennzeichnet:

a) an den Eingang einer ersten Reihenschaltung und einer zweiten Reihenschaltung, die aus je einem Verstärker, einem Tiefpass und einem Gleichrichter aufgebaut sind und deren Ausgänge mit den Eingängen eines Vergleichers verbunden sind, wird eine Referenzspannung gelegt;

b) zur Kompensation des Offsets des Vergleichers wird dem Eingang einer der beiden Reihenschaltungen eine erste Kompensationsspannurg zugeführt und so lange verändert, bis der Vergleicher anzeigt, daß die Pegel an den Ausgängen der beiden Reihenschaltungen gleich groß sind;

c) die auf diese Weise ermittelte erste Kompensationsspannung wird beibehalten;

d) dem Eingang der ersten Reihenschaltung wird anstelle der Referenzspannung das Ausgangssignal der ersten Photodiode und dem Eingang der zweiten Reihenschaltung das Ausgangssignal der zweiten Photodiode zugeführt;

e) zur Offsetkompensation wird eine zweite Kompensationsspannung an einen Eingang des Regelverstärkers gelegt und so lange verändert, bis die Pegel am Eingang des Vergleichers gleich groß sind;

f) die auf diese Weise ermittelte zweite Kompensationsspannung wird beibehalten;

Eine zweite Lösung dieser Aufgabe ist durch folgende Verfahrensschritte gekennzeichnet:

a) an die Eingänge eines Differenzverstärkers wird eine erste Referenzspannung gelegt;

b) der Pegel am Ausgang des Differenzverstärkers wird in einem Vergleicher mit einer zweiten Referenzspannung verglichen;

c) zur Kompensation des Offsets des Differenzverstärkers wird dem einen Eingang des Differenzverstärkers eine erste Kompensationsspannung zugeführt und so lange verändert, bis der Pegel am Ausgang des Differenzverstärkers mit der zweiten Referenzspannung übereinstimmt;

d) die auf diese Weise ermittelte erste Kompensationsspannung wird beibehalten;

e) anstelle der ersten Referenzspannung werden die Ausgangsspannungen der ersten und der zweiten Photodiode an die Eingänge des Differenzverstärkers gelegt;

f) zur Offsetkompensation wird an einen Eingang des Regelverstärkers eine zweite Kompensationsspannung gelegt und so lange verändert, bis die Pegel an den Eingängen des Differenzverstärkers gleich groß sind.

g) die auf diese Weise ermittelte zweite Kompensationsspannung wird beibehalten;

Es zeigen

Figur 3 ein erstes Ausführungsbeispiel

Figur 4 ein zweites Ausführungsbeispiel der Erfindung.

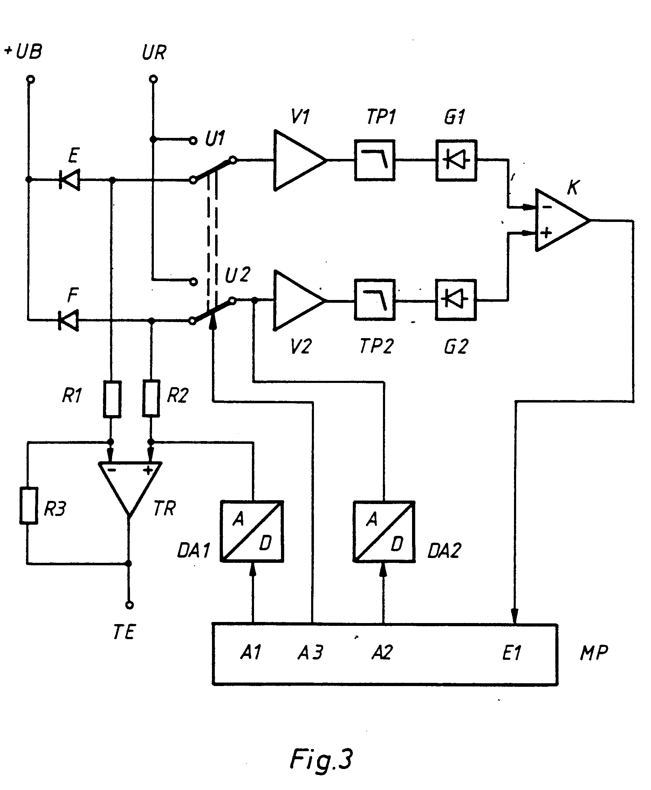

In der Figur 3 liegt an den miteinander verbundenen Kathoden der Photodioden E und F des Photodetektors PD eine Spannung +UB. Die Anode der Photodiode E ist mit dem ersten Eingang eines steuerbaren Umschalters U1 und über eine Widerstand R1 mit dem invertierenden Eingang des Regelverstärkers TR verbunden, an dessen Ausgang das Spurfehlersignal TE abgreifbar ist. Die Anode der Diode F ist mit dem ersten Eingang eines steuerbaren Umschalters U2 und über einen Widerstand R2 mit dem nichtinvertierenden Eingang des Regelverstärkers TR verbunden, dessen Ausgang über einen Widerstand R3 auf seinen invertierenden Eingang rückgekoppelt ist. An den miteinander verbundenen zweiten Eingängen der steuerbaren Umschalter U1 und U2 liegt eine Wechselspannung UR als Referenzgröße. Der Ausgang des steuerbaren Umschalters U1 ist mit dem Eingang eines Verstärkers V1 verbunden, dessen Ausgang mit dem Eingang eines Tiefpasses TP1 verbunden ist. Der Ausgang des steuerbaren Umschalters U2 ist dem Eingang eines Verstärkers V2 verbunden, dessen Ausgang mit dem Eingang eines Tiefpasses TP2 verbunden ist. Der Ausgang des Tiefpasses TP1 ist mit dem Eingang eines Gleichrichters G1 verbunden, dessen Ausgang mit den invertierenden Eingang eines Vergleichers K verbunden ist. Der Ausgang des Tiefpasses TP2 ist mit dem Eingang eines Gleichrichters G2 verbunden, dessen Ausgang mit dem nichtinvertierenden Eingang des Vergleichers K verbunden ist. Der Ausgang des Vergleichers K ist mit dem Eingang E1 einer Steuereinheit MP verbunden, deren erster Ausgang A1 mit dem Eingang eines Digital-Analog-Wandlers DA1, deren zweiter Ausgang A2 mit dem Eingang eines Digital-Analog-Wandlers DA2 und deren dritter Ausgang A3 mit den Steuereingängen der steuerbaren Umschalter U1 und U2 verbunden ist.

Bei Betrieb des CD-Spielers werden in vorgebbaren Zeitabständen von der Steuereinheit MP, für die sich ein Mikroprozessor besonders gut eignet, die steuerbaren Umschalter U1 und U2 auf die Referenzspannung UR geschaltet, so daß an beiden Eingängen des Vergleichers K dieselbe Spannung liegt. Zeigt der Vergleicher K jedoch wegen einer Off-Set-Spannung in den beiden Signalwegen, in denen die Verstärker V1 und V2, die Tiefpässe TP1 und TP2, die Gleichrichter G1 und G2 sowie auch der Vergleicher K liegen, an, daß die Spannungen an seinen Eingängen verschieden sind, obwohl sie gleich groß sind, so ändert die Steuereinheit MP den digitalen Wert an ihrem Ausgang A2 so lange, bis der Vergleicher K an seinem Ausgang Gleichheit seiner Eingangsspannungen anzeigt. Der digitale Wert am Ausgang A2 der Steuereinheit MP wird mittels des Digital-Analog-Wandlers DA2 in eine analoge Off-Set-Kompensationsspannung umgewandelt, welche die Off-Set-Spannung der Verstärker V1 und V2 sowie des Vergleichers K kompensiert.

Während der restlichen Zeit befinden sich die steuerbaren Umschalter U1 und U2 in der anderen Stellung, so daß die Photodioden E und F über die Verstärker V1 und V2, die Tiefpässe TP1 und TP2 und die Gleichrichter G1 und G2 mit dem Vergleicher K verbunden sind. Aus den Ausgangsspannungen der Photodioden E und F werden die niederfrequenten Anteile mittels der Tiefpässe TP1 und TP2 herausgesiebt und als Spitzen-, Effektiv- oder Mittelwert den Eingängen des Vergleichers K zugeführt, weil die Gleichrichter G1 und G2 als Spitzenwert-, Mittelwert- oder Effektivwertbildner wirken.

Wenn der Vergleicher K der Steuereinheit MP anzeigt, daß seine Eingangsspannungen unterschiedlich sind, ändert die Steuereinheit MP den digitalen Wert an ihrem Ausgang A1, der mittels des Digital-Analog-Wandlers DA1 als analoge Off-Set-Kompensationsspannung am nichtinvertierenden Eingang des Regelverstärkers TR liegt, so lange, bis die Eingangsspannungen am Vergleicher K gleich groß sind.

Ein Abgleich von Hand bei der Produktion entfällt ebenso wie Neuabgleiche wegen Temperaturschwankungen oder wegen Alterung der Bauteile, denn es erfolgt während des Betriebs ständig ein automatischer Neuabgleich.

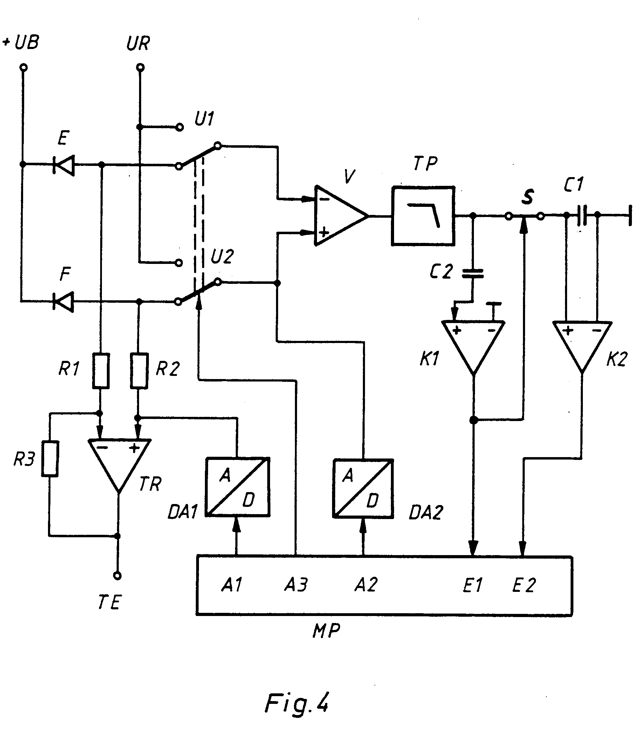

Bei dem zweiten Ausführungsbeispiel, das in Figur 4 abgebildet ist, liegt an den miteinander verbundenen Kathoden der Photodioden E und F ebenfalls eine Spannung +UB. Die Anode der Photodiode E ist mit dem ersten Eingang eines steuerbaren Umschalters U1 und über den Widerstand R1 mit dem invertierenden Eingang des Regelverstärkers TR verbunden, an dessen Ausgang des Spurfehlersignal TE abgreifbar ist. Die Anode der Photodiode F ist mit dem ersten Eingang eines steuerbaren Umschalters U2 und über einen Widerstand R2 mit dem nichtinvertierenden Eingang des Regelverstärkers TR verbunden, dessen Ausgang auf seinen invertierenden Eingang rückgekoppelt ist. Die miteinander verbundenen zweiten Eingänge der steuerbaren Umschalter U1 und U2 liegen an einer Referenzwechselspannung UR. Der Ausgang des steuerbaren Umschalters U1 ist mit dem invertierenden Eingang eines Differenzverstärkers V verbunden, dessen Ausgang mit dem Eingang eines Tiefpasses TP verbunden ist. Der Ausgang des steuerbaren Umschalters U2 ist mit dem nichtinvertierenden Eingang des Differenzverstärkers V verbunden. Der Ausgang des Tiefpasses TP ist mit dem einen Kontakt eines steuerbaren Schalters S und über eine Kapazität C2 mit dem nichtinvertierenden Eingang eines Vergleichers K1 verbunden, dessen invertierender Eingang auf Bezugspotential liegt. Der nichtinvertierende Eingang eines Vergleichers K2 ist mit dem anderen Kontakt des steuerbaren Schalters S verbunden, der invertierende Eingang liegt auf Bezugspotential. Zwischen den beiden Eingängen des Vergleichers K2 liegt eine Kapazität C1. Der Ausgang des Vergleichers K1 ist mit dem Steuereingang des steuerbaren Schalters S und mit dem ersten Eingang E1 einer Steuereinheit MP verbunden, deren zweiter Eingang E2 mit dem Ausgang des Vergleichers K2 verbunden ist. Der erste Ausgang A1 der Steuereinheit MP ist mit dem Eingang eines Digital-Analog-Wandlers DA1 verbunden, dessen Ausgang an den nichtinvertierenden Eingang des Regelverstärkers TR angeschlossen ist. Der zweite Ausgang A2 der Steuereinheit MP ist mit dem Eingang eines Digital-Analog-Wandlers DA2 verbunden, dessen Ausgang an den nichtinvertierenden Eingang des Differenzverstärkers V angeschlossen ist. Der Ausgang A3 der Steuereinheit MP ist an die Steuereingänge der beiden steuerbaren Umschalter U1 und U2 angeschlossen.

Ebenso wie beim ersten Ausführungsbeispiel wird, während der CD-Spieler in Betrieb ist, mittels der steuerbaren Umschalter U1 und U2 die Referenzwechselspannung UR an die Eingänge des Differenzverstärkers V gelegt. Ist der Differenzverstärker V mit einer Off-Set-Spannung behaftet, so zeigt der Vergleicher K1 der Steuereinheit MP, für die vorzugsweise ein Mikroprozessor vorgesehen ist, an, daß das Ausgangssignal des Differenzverstärkers V von null verschieden ist. Darauf ändert die Steuereinheit MP so lange den digitalen Wert an ihrem Ausgang A2, bis die Off-Set-Spannung des Differenzverstärkers V durch die Off-Set-Kompensationsspannung am Ausgang des Digital-Analog-Wandlers DA2 kompensiert ist. Während der restlichen Zeit sind die Anoden der Photodioden E und F über die steuerbaren Umschalter U1 und U2 mit den Eingängen des Differenzverstärkers V verbunden.

Der Vergleicher K2, dem die Gleichanteile der Spannung am Ausgang des Tiefpasses zugeführt werden, zeigt der Steuereinheit MP an, welches Vorzeichen die Differenz der Spannungen der Photodioden E und F hat. Dagegen zeigt der Vergleicher K1, an dessen Eingang die Wechselanteile der Spannung am Ausgang des Tiefpasses TP liegen, der Steuereinheit MP an, welchen Betrag die Differenz der Spannungen der Photodioden E und F hat. Die Steuereinheit MP ändert darauf den digitalen Wert an ihrem Ausgang A1, der mittels des Digital-Analog-Wandlers DA1 als analoge Off-Set-Kompensationsspannung am nichtinvertierenden Eingang des Regelverstärkers TR liegt, so lange, bis die Spannungen an den Eingängen des Differenzverstärkers V gleich groß sind. Dann öffnet die Steuereinheit MP den bisher geschlossenen steuerbarer Schalter S.

Die Erfindung ist für DRAW-Disc-Spieler, magneto-optische Geräte und Videoplattenspieler ebenso gut geeignet wie für CD-Spieler.

**Patentansprüche**

1. Verfahren zur Offsetkompensation in einem Gerät zur Wiedergabe von Daten, die mittels einer optischen Abtastvorrichtung aus den Datenspuren eines Aufzeichnungsträgers lesbar sind, indem mindestens ein Lichtstrahl auf den Aufzeichnungsträger mittels eines Fokusregelkreises fokussierbar und mittels eines Spurregelkreises auf den Datenspuren führbar ist, indem der Lichtstrahl vom Aufzeichnungsträger auf einen Photodetektor (PD), der aus mehreren Photodioden (A, B, G, D, E, F) aufgebaut ist, reflektiert wird, mittels dem ein elektrisches Datensignal (HF), ein Fokusfehlersignal (FE) als Regelsignal für den Fokusregelkreis und ein Spurfehlersignal (TE) als Regelsignal für den Spurregelkreis erzeugt werden, indem die Differenz der Ausgangssignale einer ersten und einer zweiten Photodiode (E, F) in einem Regelverstärker (TR) gebildet wird, **gekennzeichnet durch** folgende Verfahrensschritte:

   a) an den Eingang einer ersten Reihenschaltung und einer zweiten Reihenschaltung, die aus je einem Verstärker (V1, V2), einem Tiefpass (TP1, TP2) und einem Gleichrichter (G1, G2) aufgebaut sind und deren Ausgänge mit den Eingängen eines Vergleichers (K) verbunden sind, wird eine Referenzspannung (UR) gelegt;
   b) zur Kompensation des Offsets des Vergleichers (K) wird dem Eingang einer der beiden Reihenschaltungen eine erste Kompensationsspannung zugeführt und so lange verändert, bis der Vergleicher (K) anzeigt, daß die Pegel an den Ausgängen der beiden Reihenschaltungen gleich groß sind;
   c) die auf diese Weise ermittelte erste Kompensationsspannung wird beibehalten;
   d) dem Eingang der ersten Reihenschaltung wird anstelle der Referenzspannung (UR) das Ausgangssignal der ersten Photodiode (E) und dem Eingang der zweiten Reihenschaltung das Ausgangssignal der zweiten Photodiode (F) zugeführt;

e) zur Offsetkompensation wird eine zweite Kompensationsspannung an einen Eingang des Regelverstärkers (TR) gelegt und so lange verändert, bis die Pegel am Eingang des Vergleichers (K) gleich groß sind.

2. Verfahren zur Offsetkompensation in einem Gerät zur Wiedergabe von Daten, die mittels einer optischen Abtastvorrichtung aus den Datenspuren eines Aufzeichnungsträgers lesbar sind, indem mindestens ein Lichtstrahl auf den Aufzeichnungsträger mittels eines Fokusregelkreises fokussierbar und mittels eines Spurregelkreises auf den Datenspuren führbar ist, indem der Lichtstrahl vom Aufzeichnungsträger auf einen Photodetektor (PD), der aus mehreren Photodioden (A, B, C, D, E, F) aufgebaut ist, reflektiert wird, mittels dem ein elektrisches Datensignal (HF), ein Fokusfehlersignal (FE) als Regelsignal für den Fokusregelkreis und ein Spurfehlersignal (TE) als Regelsignal für den Spurregelkreis erzeugt werden, indem die Differenz der Ausgangssignale einer ersten und einer zweiten Photodiode (E, F) in einem Regelverstärker (TR) gebildet wird, **gekennzeichnet durch** folgende Verfahrensschritte:

a) an die Eingänge eines Differenzverstärkers (V) wird eine erste Referenzspannung (UR) gelegt;

b) der Pegel am Ausgang des Differenzverstärkers (V) wird in einem Vergleicher (K1) mit einer zweiten Referenzspannung verglichen;

c) zur Kompensation des Offsets des Differenzverstärkers (V) wird dem einen Eingang des Differenzverstärkers (V) eine erste Kompensationsspannung zugeführt und so lange verändert, bis der Pegel am Ausgang des Differenzverstärkers (V) mit der zweiten Referenzspannung übereinstimmt;

d) die auf diese Weise ermittelte erste Kompensationsspannung wird beibehalten;

e) anstelle der ersten Referenzspannung (UR) werden die Ausgangsspannungen der ersten und der zweiten Photodiode (E, F) an die Eingänge des Differenzverstärkers (V) gelegt;

f) zur Offsetkompensation wird an einen Eingang des Regelverstärkers (TR) eine zweite Kompensationsspannung gelegt und so lange verändert, bis die Pegel an den Eingängen des Differenzverstärkers (V) gleich groß sind.

3. Gerät zur Durchführung des Verfahrens nach Anspruch 1, **dadurch gekennzeichnet, daß** eine Elektrode der Photodiode (E), deren Photospannung zur Erzeugung des Spurfehlersignals (TE) dient, mit dem invertierenden Eingang des Reglverstärkers (TR) des Spurregelkreises und mit dem ersten Eingang eines ersten steuerbaren Umschalters (U1) verbunden ist, dessen Ausgang über eine Reihenschaltung aus einem ersten Tiefpaß (TP1) und einem ersten Gleichrichter (G1) mit dem invertierenden Eingang eines Vergleichers (K) verbunden ist, daß die gleiche Elektrode der anderen Photodiode (F), deren Photospannung ebenfalls zur Erzeugung des Spurfehlersignals (TE) dient, mit dem nichtinvertierenden Eingang des Regelverstärkers (TR) des Spurregelkreises und mit dem ersten Eingang eines zweiten steuerbaren Umschalters (U2) verbunden ist, dessen Ausgang über eine Reihenschaltung aus einem zweiten Tiefpaß (TP2) und einem zweiten Gleichrichter (G2) mit dem nichtinvertierenden Eingang des Vergleichers (K) verbunden ist, dessen Ausgang mit dem Eingang (E1) einer Steuereinheit (MP) verbunden ist, daß der erste Ausgang (A1) der Steuereinheit (MP) mit dem Eingang eines ersten Digital-Analog-Wandlers (DA1) verbunden ist, dessen Ausgang mit dem nichtinvertierenden Eingang des Regelverstärkers (TR) des Spurregelkreises verbunden ist, daß der zweite Ausgang (A2) der Steuereinheit (MP) mit dem Eingang eines zweiten Digital-Analog-Wandlers (DA2) verbunden ist, dessen Ausgang mit dem Ausgang eines der beiden steuerbaren Umschalter (U2) verbunden ist, daß am zweiten Eingang der beiden steuerbaren Umschalter (U1, U2) eine Referenzspannung (UR) liegt und daß ein dritter Ausgang (A3) der Steuereinheit (MP) mit den Steuereingängen der beiden steuerbaren Umschalter (U1, U2) verbunden ist.

4. Gerät nach Anspruch 3, **dadurch gekennzeichnet,** daß zwischen den Photodioden (E, F) und den Tiefpässen (TP1, TP2) je ein Verstärker (V1, V2) vorgesehen ist.

5. Gerät nach Anspruch 3 oder 4, **dadurch gekennzeichnet,** daß die Gleichrichter (G1, G2) als Spitzenwert-, Mittelwert- oder Effektivwertbildner wirken.

6. Gerät zur Durchführung des Verfahrens nach Anspruch 2, **dadurch gekennzeichnet, daß** die eine Elektrode der einen Photodiode (E), deren Photospannung zur Erzeugung des Spurfehlersignals (TE) dient, mit dem invertierenden Eingang des Regelverstärkers (TR) des Spurregelkreises und mit dem ersten Eingang eines ersten steuerbaren Umschalters (U1) verbunden ist, dessen Ausgang mit dem einen Eingang eines Differenzverstärkers (V) verbunden ist, daß die gleiche Elektrode der anderen Photodiode (F), deren Photospannung ebenfalls zur Erzeugung des Spurfehlersignals (TE) dient, mit dem nichtinvertierenden Eingang des Regelverstärkers (TR) des Spurregelkreises und mit dem ersten Eingang eines zweiten steuerbaren Umschalters (U2) verbunden ist, dessen Ausgang mit dem anderen Eingang des Differenzverstärkers (V) verbunden ist, dessen Ausgang mit dem Eingang eines Tiefpasses (TP) verbunden ist, daß der Ausgang des Tiefpasses (TP) über eine erste Kapazität (C2) mit dem einen Eingang eines ersten Vergleichers (K1) und über einen steuerbaren Schalter (S) mit dem einen Eingang eines zweiten Vergleichers (K2) verbunden ist, daß der andere Eingang des ersten Vergleichers (K1), dessen Ausgang mit dem ersten Eingang (E1) einer Steuereinheit (MP) und mit dem Steuereingang des steuerbaren Schalters (S) verbunden ist, auf Bezugspotential liegt, daß der andere Eingang des zweiten Vergleichers (K2) ebenfalls auf Bezugspotential liegt, daß zwischen den Eingängen des zweiten Vergleichers (K2) eine zweite Kapazität (C1) vorgesehen ist, daß der Ausgang des zweiten Vergleichers (K2) mit dem zweiten Eingang (E2) der Steuereinheit (MP) verbunden ist, deren erster Ausgang (A1) mit dem Eingang eines ersten Digital-Analog-Wandlers (DA1) verbunden ist, daß der Ausgang des ersten Digital-Analog-Wandlers (DA1) mit dem nichtinvertierenden Eingang des Regelverstärkers (TR) des Spurregelkreises verbunden ist, daß ein zweiter Ausgang (A2) der Steuereinheit (MP) mit dem Eingang eines zweiten Digital-Analog-Wandlers (DA2) verbunden ist, dessen Ausgang mit einem Eingang des Differenzverstärkers (V) verbunden ist, daß jeweils am zweiten Eingang der beiden steuerbaren Umschalter (U1, U2) eine Referenzspannung (UR) liegt und daß ein dritter Ausgang (A3) der Steuereinheit (MP) mit den Steuereingängen der beiden steuerbaren Umschalter (U1, U2) verbunden ist.

7. Gerät nach Anspruch 3, 4, 5 oder 6, **dadurch gekennzeichnet,** daß für die Steuereinheit (MP) ein Mikroprozessor vorgesehen ist.

**Claims**

1. Method for the off-set compensation in an apparatus for the reproduction of data which is readable by means of an optical scanning device from the data tracks of a record carrier, in which at least one light beam is focusable on the record carrier by means of a focusing control loop and is guidable onto the data tracks of the record carrier by means of a tracking control loop, wherein the light beam is reflected from the record carrier onto a photodetector (PD), which is built up of several photo-diodes (A, B, C, D, E, F), by means of which an electrical data signal (HF), a focusing error signal (FE) as control signal for the focusing control loop and a tracking error signal (TE) as control signal for the tracking control loop are generated, in which the difference of the output signals of a first and of a second photo-diode (E, F) is formed in a servo amplifier (TR), characterised by the following method steps:

   a) a reference voltage (UR) is applied to the input of a first series circuit and of a second series circuit which are each built up of an amplifier (V1, V2), a low pass filter (TP1, TP2) and a rectifier (G1, G2) and their outputs are connected to the inputs of a comparator (K);

   b) for the compensation of the off-set of the comparator (K), a first compensating voltage is supplied to the input of one of the two series circuits and this is varied until such time as the comparator (K) indicates that the levels at the outputs of the two series circuits are equally great;

   c) the first compensating voltage determined in this manner is retained;

   d) the output signal of the first photo-diode (E) is supplied to the input of the first series circuit instead of the reference voltage (UR), and the output signal of the second photo-diode (F) is supplied to the input of the second series circuit;

   e) for the off-set compensation, a second compensating voltage is applied to an input of the servo amplifier (TR) and is varied until such time as the levels at the input of the comparator (K) are equally great.

2. Method for the off-set compensation in an apparatus for the reproduction of data which is readable by means of an optical scanning device from the data tracks of a record carrier, in which at least one light beam is focusable on the record carrier by means of a focusing control loop and is guidable onto the data tracks of the record carrier by means of a tracking control loop, wherein the light beam is reflected from the record carrier onto a photodetector (PD), which is built up of several photo-diodes (A, B, C, D, E, F), by means of which an electrical data signal (HF), a focusing error signal (FE) as control signal for the focusing control loop and a tracking error signal (TE) as control signal for the tracking control loop are generated, wherein the difference of the output signals of a first and of a second photo-diode (E, F) is formed in a servo amplifier (TR), characterised by the following method steps:

a) a first reference voltage (UR) is applied to the inputs of a differential amplifier (V);

b) the level at the output of the differential amplifier (V) is compared with a second reference voltage in a comparator (K1);

c) for the compensation of the off-set of the differential amplifier (V), a first compensating voltage is supplied to the one input of the differential amplifier (V) and is varied until such time as the level at the output of the differential amplifier (V) coincides with the second reference voltage;

d) the first compensating voltage determined in this manner is retained;

e) the output voltages of the first and of the second photo-diodes (E, F) are applied to the inputs of the differential amplifier (V) instead of the first reference voltage (UR);

f) for the off-set compensation, a second compensating voltage is applied to an input of the servo amplifier (TR) and is varied until such time as the levels at the inputs of the differential amplifier (V) are equally great.

3. Apparatus for carrying out the method according to Claim 1, characterised in that, one electrode of the photo-diode (E), whose photo electric voltage serves for the generation of the tracking error control signal (TE), is connected to the inverting input of the servo amplifier (TR) of the tracking control loop and to the first input of a controllable change over switch (U1) whose output is connected to the inverting input of a comparator (K) via a series circuit comprising a first low pass filter (TP1) and a first rectifier (G1), that the same electrode of the other diode (F), whose photo electric voltage likewise serves for the generation of the tracking error control signal (TE), is connected to the non-inverting input of the servo amplifier (TR) of the tracking control loop and to the first input of a second controllable change over switch (U2) whose output is connected via a series circuit comprising a second low pass filter (TP2) and a second rectifier (G2) to the non-inverting input of the comparator (K) whose output is connected to the input (E1) of a control unit (MP), that the first output (A1) of the control unit (MP) is connected to the input of a first digital to analogue converter (DA1) whose output is connected to the non-inverting input of the servo amplifier (TR) of the tracking error control loop, that the second output (A2) of the control unit (MP) is connected to the input of a second digital to analogue converter (DA2) whose output is connected to the output of one of the two controllable change over switches (U2), that a reference voltage (UR) is present on the second input of the two controllable change over switches (U1, U2), and that a third output (A3) of the control unit (MP) is connected to the control inputs of the two controllable change over switches (U1, U2).

4. Apparatus in accordance with Claim 3, characterised in that, an amplifier (V1, V2) is provided between each of the photo-diodes (E, F) and the low pass filters (TP1, TP2).

5. Apparatus in accordance with Claim 3 or 4, characterised in that, the rectifiers (G1, G2) are effective to form peak values, average values, or effective values.

6. Apparatus for carrying out the method in accordance with Claim 2, characterised in that, the one electrode of the one photo-diode (E), whose photo electric voltage serves for the generation of the tracking error control signal (TE), is connected to the inverting input of the servo amplifier (TR) of the tracking control loop and to the first input of a first controllable change over switch (U1) whose output is connected to the one input of a differential amplifier (V), that the same electrode of the other diode (F), whose photo electric voltage likewise serves for the generation of the tracking error control signal (TE), is connected to the non-inverting input of the servo amplifier (TR) of the tracking control loop and to the first input of a second controllable change over switch (U2) whose output is connected to the other input of the differential amplifier (V), whose output is connected to the input of a low pass filter (TP), that the output of the low pass filter (TP) is connected via a first capacitance (C2) to the one input of a first comparator (K1) and via a controllable switch (S) to the one input of a second comparator (K2), that the other input of the first comparator (K1), whose output is connected to the first input (E1) of a control unit (MP) and to the control input of the controllable switch (S), is at reference potential, that the other input of the second comparator (K2) is likewise at reference potential, that a second capacitance (C1) is provided between the inputs of the second comparator (K2), that the output of the second comparator (K2) is connected to the second input (E2) of the control unit (MP), whose first output (A1) is connected to the input of a first digital to analogue converter (DA1), that the output of the first digital to analogue converter (DA1) is connected to the non-inverting input of the servo amplifier (TR) of the tracking control loop, that a second output (A2) of the control unit (MP) is connected to the input of a second digital to analogue converter (DA2), whose output is connected to one input of the differential amplifier (V), that a reference voltage (UR) is present on the respective second input of the two controllable change over switches (U1, U2) and that a third output (A3) of the control unit (MP) is connected to the control inputs of the two controllable change over switches (U1, U2).

7. Apparatus in accordance with Claim 3, 4, 5 or 6, characterised in that, a microprocessor is provided for the control unit (MP).

**Revendications**

1. Procédé pour la compensation de l'offset dans un appareil pour la reproduction de données qui peuvent être lues au moyen d'un dispositif de balayage optique à partir des pistes de données d'un support d'enregistrement, au moins un faisceau lumineux pouvant être focalisé sur le support d'enregistrement au moyen d'un circuit de réglage de foyer et pouvant être guidé sur les pistes de données au moyen d'un circuit de réglage de piste, le faisceau lumineux étant réfléchi par le support d'enregistrement sur un détecteur photoélectrique (PD), composé de plusieurs diodes photoélectriques (A, B, C, D, E, F), au moyen duquel sont produits un signal électrique de données (HF), un signal d'erreur de foyer (FE) comme signal de réglage pour le circuit de réglage de foyer et un signal d'erreur de piste (TE) comme signal de réglage pour le circuit de réglage de piste, la différence des signaux de départ d'une première et d'une seconde diode photoélectrique (E. F) étant formée dans un amplificateur de réglage (TR), **caractérisé par** les étapes de procédé suivantes :

    a) une tension de référence (UR) est appliquée à l'entrée d'un premier montage en série et d'un second montage en série qui sont constitués chacun par un amplificateur (V1, V2), un passe-bas (TP1, TP2) et un redresseur (G1, G2) et dont les sorties sont reliées aux entrées d'un comparateur (K);

    b) une première tension de compensation est amenée, pour la compensation de l'offset du comparateur (K), à l'entrée de l'un des deux montages en série et est modifiée jusqu'à ce que le comparateur (K) indique que les niveaux aux sorties des deux montages en série sont de même grandeur ;

    c) la première tension de compensation déterminée de cette manière est gardée;

    d) le signal de sortie de la première diode photoélectrique (E) est amené à l'entrée du premier montage en série à la place de la tension de référence (UR) et le signal de sortie de la seconde diode photoélectrique (F) est amené à l'entrée du second montage en série ;

    e) pour la compensation de l'offset, une seconde tension de compensation est appliquée à une entrée de l'amplificateur de réglage (TR) et est modifiée jusqu'à ce que les niveaux à l'entrée du comparateur (K) soient de même grandeur.

2. Procédé pour la compensation de l'offset dans un appareil pour la reproduction de données qui peuvent être lues au moyen d'un dispositif de balayage optique à partir des pistes de données d'un support d'enregistrement, au moins un faisceau lumineux pouvant être focalisé sur le support d'enregistrement au moyen d'un circuit de réglage de foyer et pouvant être guidé sur les pistes de données au moyen d'un circuit de réglage de piste, le faisceau lumineux étant réfléchi par le support d'enregistrement sur un détecteur photoélectrique (PD) composé de plusieurs diodes photoélectriques (A, B, C, D, E, F) au moyen duquel sont produits un signal électrique de données (HF), un signal d'erreur de foyer (FE) comme signal de réglage pour le circuit de réglage de foyer et un signal d'erreur de piste (TE) comme signal de réglage pour le circuit de réglage de piste, la différence des signaux de départ d'une première et d'une seconde diode photoélectrique (E, F) étant formée dans un amplificateur de réglage (TR), **caractérisé par** les étapes de procédé suivantes :

    a) une première tension de référence (UR) est appliquée aux entrées d'un amplificateur différenciateur (V) ;

    b) le niveau à la sortie de l'amplificateur différenciateur (V) est comparé à une seconde tension de référence dans un comparateur (K1) ;

    c) pour la compensation de l'offset de l'amplificateur différenciateur (V), une première tension de compensation est amenée à l'une des entrées de l'amplificateur différenciateur (V) et est modifiée jusqu'à ce que le niveau à la sortie de l'amplificateur différenciateur (V) coïncide avec la seconde tension de référence ;

d) la première tension de compensation déterminée de cette manière est gardée;

e) à la place de la première tension de référence (UR), les tensions de sortie de la première diode photoélectrique et de la seconde diode photoélectrique (E, F) sont appliquées aux entrées de l'amplificateur différenciateur (V) ;

f) pour la compensation de l'offset, une seconde tension de compensation est appliquée à une entrée de l'amplificateur de réglage (TR) et est modifiée jusqu'à ce que les niveaux aux entrées de l'amplificateur différenciateur (V) soient de même grandeur.

3. Appareil pour la réalisation du procédé selon la revendication 1, **caractérisé en ce** qu'une électrode de la diode photoélectrique (E), dont la tension photoélectrique sert à produire le signal d'erreur de piste (TE), est reliée à l'entrée d'inversion de l'amplificateur de réglage (TR) du circuit de réglage de piste et à la première entrée d'un premier commutateur qui peut être commandé (U1) dont la sortie est reliée à l'entrée d'inversion d'un comparateur (K) par un montage en série composé d'un premier passe-bas (TP1) et d'un premier redresseur (G1), que la même électrode de l'autre diode photoélectrique (F), dont la tension photoélectrique sert également à produire le signal d'erreur de piste (TE), est reliée à l'entrée directe de l'amplificateur de réglage (TR) du circuit de réglage de piste et à la première entrée d'un second commutateur qui peut être commandé (U2) dont la sortie est reliée, par un montage en série composé d'un second passe-bas (TP2) et d'un second redresseur (G2), à l'entrée directe du comparateur (K) dont la sortie est reliée à l'entrée (E1) d'une unité de commande (MP), que la première sortie (A1) de l'unité de commande (MP) est reliée à l'entrée d'un premier convertisseur numérique-analogique (DA1) dont la sortie est reliée à l'entrée directe de l'amplificateur de réglage (TR) du circuit de réglage de piste, que la seconde sortie (A2) de l'unité de commande (MP) est reliée à l'entrée d'un second convertisseur numérique-analogique (DA2) dont la sortie est reliée à la sortie d'un des deux commutateurs (U2) qui peuvent être commandés qu'une tension de référence (UR) est appliquée à la seconde entrée des deux commutateurs qui peuvent être commandés (U1, U2) et qu'une troisième sortie (A3) de l'unité de commande (MP) est reliée aux entrées de commande des deux commutateurs qui peuvent être commandés (U1, U2).

4. Appareil selon la revendication 3, **caractérisé en ce** qu'un amplificateur (V1, V2) est prévu respectivement entre les diodes photoélectriques (E, F) et entre les passe-bas (TP1, TP2).

5. Appareil selon la revendication 3 ou 4, **caractérisé en ce** que les redresseurs (G1, G2) agissent comme des formateurs de valeur de crête, de valeur moyenne ou de valeur effective.

6. Appareil pour la réalisation du procédé selon la revendication 2, **caractérisé en ce** que l'une des électrodes de l'une des diodes photoélectriques (E), dont la tension photoélectrique sert à produire le signal d'erreur de piste (TE), est reliée à l'entrée d'inversion de l'amplificateur de réglage (TR) du circuit de réglage de piste et à la première entrée d'un premier commutateur qui peut être commandé (U1) dont la sortie est reliée à l'une des entrées d'un amplificateur différenciateur (V), que la même électrode de l'autre diode photoélectrique (F), dont la tension photoélectrique sert également à produire le signal d'erreur de piste (TE), est reliée à l'entrée d'inversion de l'amplificateur de réglage (TR) du circuit de réglage de piste et à la première entrée d'un second commutateur qui peut être commandé (U2) dont la sortie est reliée à l'autre entrée de l'amplificateur différenciateur (V) dont la sortie est reliée à l'entrée d'un passe-bas (TP), que la sortie du passe-bas (TP) est reliée, par un premier condensateur (C2), à l'une des entrées d'un premier comparateur (K1) et, par un commutateur qui peut être commandé (S), à l'une des entrées d'un second comparateur (K2), que l'autre entrée du premier comparateur (K1), dont la sortie est reliée à la première entrée (E1) d'une unité de commande (MP) et à l'entrée de commande du commutateur qui peut être commandé (S), est sur le potentiel de référence, que l'autre entrée du second comparateur (K2) est également sur le potentiel de référence, qu'un second condensateur (C1) est prévu entre les entrées du second comparateur (K2), que la sortie du second comparateur (K2) est reliée à la seconde entrée (E2) de l'unité de commande (MP) dont la première sortie (A1) est reliée à l'entrée d'un premier convertisseur numérique-analogique (DA1), que la sortie du premier convertisseur numérique-analogique (DA1) est reliée à l'entrée directe de l'amplificateur de réglage (TR) du circuit de réglage de piste, qu'une seconde sortie (A2) de l'unité de commande (MP) est reliée à l'entrée d'un second convertisseur numérique-analogique (DA2) dont la sortie est reliée à une entrée de l'amplificateur différenciateur (V), qu'une tension de référence (UR) est appliquée respectivement à la seconde entrée de chacun des deux commutateurs qui peuvent être commandés (U1, U2) et qu'une troisième sortie (A3) de l'unité de commande (MP) est reliée aux entrées de commande des deux commutateurs qui peuvent être commandés (U1, U2).

7. Appareil selon la revendication 3, 4, 5 ou 6, **caractérisé en ce** qu'un microprocesseur est prévu pour l'unité de commande (MP).

a

$$HF = AS + BS + CS + DS$$
$$FE = (AS + CS) - (BS + DS) = 0$$
$$TE = ES - FS = 0$$

b

$$FE = (AS + CS) - (BS + DS) < 0$$
$$TE = ES - FS = 0$$

c

$$FE = (AS + CS) - (BS + DS) > 0$$
$$TE = ES - FS = 0$$

d

$$FE = (AS + CS) - (BS + DS) = 0$$
$$TE = ES - FS < 0$$

e

$$FE = (AS + CS) - (BS + DS) = 0$$
$$TE = ES - FS > 0$$

Fig. 1

12

*Fig. 2*

Fig.3

14

Fig. 4